Europäisches Patentamt

European Patent Office

Office européen des brevets

(19)

(11) Veröffentlichungsnummer: **0 007 414**
**B1**

(12) **EUROPÄISCHE PATENTSCHRIFT**

(45) Veröffentlichungstag der Patentschrift:
22.07.81

(21) Anmeldenummer: 79101883.1

(22) Anmeldetag: 11.06.79

(51) Int. Cl.³: **H 03 K 21/18,** G 01 D 3/08,
G 06 F 11/00

(54) Verfahren zur Ueberwachung einer mehrstelligen, im Multiplexverfahren betriebenen Anzeige sowie nach diesem Verfahren betriebene Anzeige.

(30) Priorität: 18.07.78 CH 7755/78

(43) Veröffentlichungstag der Anmeldung:
06.02.80 Patentblatt 80/3

(45) Bekanntmachung des Hinweises auf die Patenterteilung:
22.07.81 Patentblatt 81/29

(84) Benannte Vertragsstaaten:
DE FR GB NL

(56) Entgegenhaltungen:
DE-A-2 325 408
US-A-3 753 226
ELEKTRONIK, Heft 10, 1970,
Zeilen 339—342
München, DE.
G. MÜHLSTADT: »Code-Umsetzer für Sieben-Segment-Zifferndarstellung«

(73) Patentinhaber: Mettler Instrumente AG,
CH-8606 Greifensee (CH)

(72) Erfinder: Jonath, Eberhard, Dipl.-Ing.,
Sunnebüelstrasse 44, CH-8604 Volketswil (CH)

**Verfahren zur Überwachung einer mehrstelligen, im Multiplexverfahren
betriebenen Anzeige sowie nach diesem Verfahren betriebene Anzeige**

Die Erfindung betrifft ein Verfahren zur Überwachung einer mehrstelligen, im Multiplexverfahren betriebenen Anzeige sowie eine nach diesem Verfahren betriebene Anzeige.

Aus der DE-OS 27 12 398 ist eine Überwachungsschaltung bekanntgeworden, bei der jeder Segmentleitung eine Vergleichsschaltung zugeordnet ist. Eine ähnliche Überwachungsschaltung offenbart die US-PS 3 943 500. Die genannten Überwachungsschaltungen sind mit erheblichem Aufwand verbunden, außerdem prinzipiell nur bei Anzeigen verwendbar, bei denen in den Segmentleitungen nennenswerte Ströme fließen (z. B. Leuchtdioden-Anzeigen).

Beispielsweise aus der DE-OS 24 06 093 ist es bekannt, wenigstens einen Teil der gleichrangigen Segmente in Reihe galvanisch miteinander zu verbinden. Eine Überwachungsschaltung ist diesem Zitat jedoch nicht zu entnehmen.

Aufgabe der vorliegenden Erfindung war es, eine Überwachungsschaltung zu schaffen, die auf alle im Multiplexverfahren betriebenen Segmentanzeigen anwendbar ist, nur mäßigen Mehraufwand bedingt und insbesondere für Anzeigen von Waagen geeignet sein soll.

Zur Lösung dieser Aufgabe wird gemäß der Erfindung vorgeschlagen, daß den mit gleichrangigen Segment-Elektroden der Anzeige galvanisch verbundenen Segment-Elektroden einer nicht der Anzeigeablesung dienende Prüfstelle während eines zusätzlichen Taktes der Multiplexschaltung ein Überprüfungssignal zugeführt wird.

Bei reinen Ziffernanzeigen, wie sie insbesondere auch bei Waagen überwiegend vorkommen, genügt es, nur diejenigen fünf Segmente zu überwachen, die bei Ausfall falsche, aber nicht aus sich heraus als falsch erkennbare Anzeigen liefern. In anderen Fällen wären alle Segmente zu überprüfen.

In manchen Fällen ist es zweckmäßig, wenn die Prüfstelle durch eine Einrichtung überwacht wird, die bei einem Defekt ein Alarmsignal auslöst.

Gemäß der Erfindung ist ferner eine mehrstellige, im Multiplexverfahren betriebene Segmentanzeige, bei welcher gleichrangige Segment-Elektroden durch je eine gemeinsame Leitung miteinander verbunden sind, dadurch gekennzeichnet, daß wenigstens ein Teil der Leitungen ferner mit Anzeigesegmenten einer nicht zur Anzeigeablesung dienenden Prüfstelle verbunden ist. Die Anzahl Segmente der Prüfstelle muß dabei nicht zwangsläufig der Anzahl Segmente der einzelnen Stellen entsprechen. Beispielsweise kann ein zusätzliches Segment in der Prüfstelle dem Dezimalpunkt entsprechen, ferner können weitere Prüfstellensegmente zusätzliche Symbole in der Anzeige (wie z. B. Vorzeichen oder Maßeinheiten) überwachen.

Die Anordnung der Prüfstelle ist weitgehend frei. Sie kann grundsätzlich entweder der Anzeige sichtbar zugeordnet oder aber abgedeckt sein. Im letzten Fall sieht eine bevorzugte Ausbildung vor, daß zur Überwachung der Prüfstelle Fotozellen und eine von diesen gesteuerte Alarmeinrichtung vorgesehen sind. Dabei kann, je nach Gestaltung der Prüfstelle, jeweils ein oder mehrere oder gar alle Prüfstellensegmente von einer Fotozelle überwacht werden.

Die Prüfstelle kann im einfachsten Fall eine den Anzeigestellen gleiche Stelle sein, die jedoch nicht zur Anzeige des Meßwertes gehört. Dann ist sie zweckmäßigerweise abgedeckt. In der offenen, d. h. dem Auge zugänglichen Variante kann sie beispielsweise aus Kreissegmenten bestehen.

Nachstehend wird ein Ausführungsbeispiel der Erfindung an Hand der Zeichnung näher beschrieben. In der Zeichnung stellen dar

Fig. 1 die Schaltung einer dreistelligen Anzeige,

Fig. 2 eine einzelne Anzeigestelle, und

Fig. 3 eine Überwachungsschaltung.

Für das Ausführungsbeispiel wurde eine Sieben-Segment-Flüssigkristallanzeige für eine Waage gewählt, der Übersichtlichkeit der Darstellung wegen nur mit drei Anzeigestellen. Es versteht sich, daß übliche Anzeigen regelmäßig mehr Stellen aufweisen, was aber am darzustellenden Prinzip nichts ändert. Allenfalls wäre zu erwähnen, daß der Aufwand für die erfindungsgemäße Überwachungsschaltung von der Anzahl Anzeigestellen unabhängig ist, also mit zunehmender Anzahl Anzeigestellen relativ abnimmt.

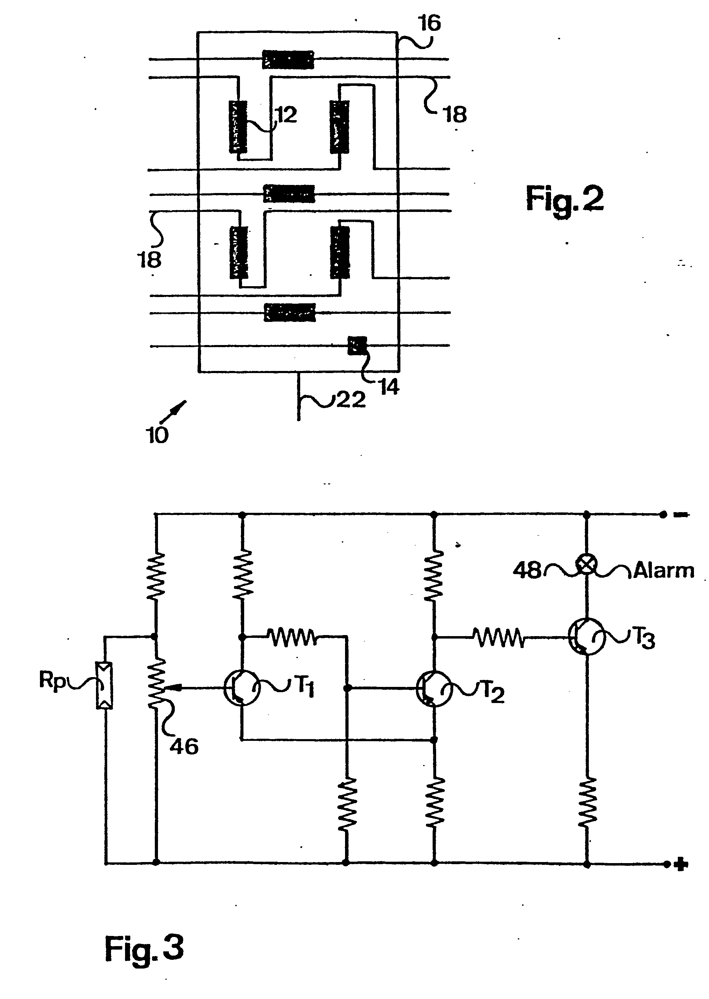

Jede Anzeigestelle 10 umfaßt sieben auf ein Substrat aufgedampfte Segmentelektroden 12 sowie einen Dezimalpunkt 14. In der Zeichenebene dahinter gehört zu jeder Anzeigestelle eine Gegenelektrode 16. Gleichrangige Segmente sind durchgehend galvanisch miteinander verbunden mittels Leitungen 18 (siehe auch Fig. 2).

Ein Taktgeber 20 steuert über Leitungen 22 die sequentielle Versorgung der Gegenelektroden 16 sowie der jeweils ausgewählten Segmentelektroden 12 (und ggfs. 14) mit Wechselspannung. Dabei werden die anzuzeigenden Daten (Leitungen 24) einem Speicher 26 und von dort über Leitungen 28 einem Decoder-Treiber 30 zugeführt, der die Segmentleitungen 18 ansteuert.

Die bis hierher beschriebene Anordnung ist konventionell und bedarf daher keiner weiteren Erläuterungen. Erfindungsgemäß ist nun eine Prüfstelle 32 vorgesehen. Sie umfaßt acht symmetrisch angeordnete Segmentelektroden 34, die etwa die Form von Kreissektoren haben. Jeder Gruppe gleichrangiger Anzeigesegmente 12 sowie den Dezimalpunkten 14 ist je eine Segmentelektrode 34 zugeordnet (Leitungen 18).

Wie bei den Anzeigestellen ist dahinter eine Gegenelektrode 36 angeordnet, die über eine Leitung 38 vom Taktgeber 20 angesteuert wird. Ein zusätzlicher Speicher 40 ist sowohl mit dem Taktgeber (Leitung 42) als auch mit dem Decoder-Treiber 30 (Leitung 44) verbunden und hat ein Kontrollsignal für alle acht Segmentelektroden 12, 14 gespeichert.

Im Betrieb werden, wie üblich, die Anzeigestellen 10 in starrer Sequenz nacheinander angesteuert, wobei jeweils die einer bestimmten Anzeigestelle zugeordneten Segmentelektroden 12 (und ggfs. 14) gemäß dem jeweiligen Anzeigewert im Speicher 26 erregt werden. Erfindungsgemäß ist nun ein zusätzlicher Takt vorgesehen, währenddessen die Gegenelektrode 36 und alle Segmentelektroden 12, 14 erregt werden. Ein Defekt in einer Segmentleitung oder einem Segment oder aber ein Kurzschluß wird durch Ausfall des entsprechenden Segmentes in der Prüfstelle 32 sofort optisch erkennbar.

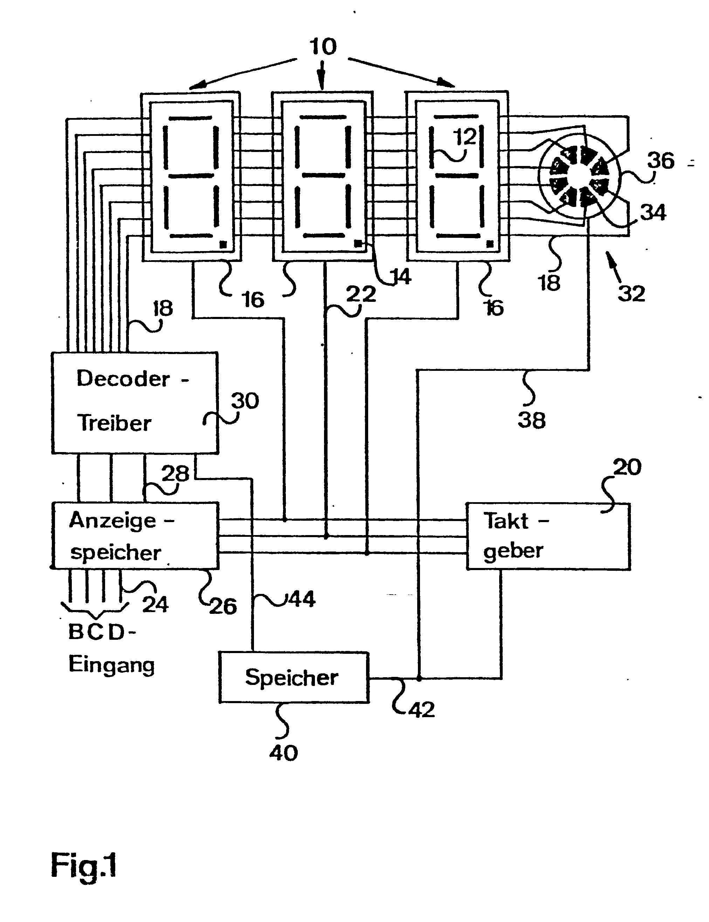

Ist eine visuelle Kontrolle durch die Bedienungsperson nicht zweckmäßig, so kann die Prüfstelle 32 abgedeckt und ihr eine fotoelektrische Abtastung (in Fig. 1 nicht gezeigt) zugeordnet werden. Ein Beispiel hierfür zeigt Fig. 3: Ein Potentiometer 46 wird so justiert, daß bei ordnungsgemäßer Funktion der Anzeige, d. h. bei voller Beleuchtung eines Fotowiderstandes $R_p$, an der Basis eines Eingangs-Transistors $T_1$ eine solche Spannung liegt, daß $T_1$ noch sperrt. Damit bleibt ein Transistor $T_2$ eines $T_1$ und $T_2$ umfassenden Schmitt-Triggers geöffnet und ein Transistor $T_3$ der Verstärkerstufe erhält keine genügende Basisspannung, um eine Alarmeinrichtung (Lampe) 48 zu aktivieren. Erhöht sich nun durch Schwächerwerden der Beleuchtung der Widerstand von $R_p$, so wächst damit auch die Basisspannung von $T_1$. Letzterer öffnet, $T_2$ schließt und die Lampe 48 wird aufleuchten.

Wie eingangs erwähnt, kann die Überwachung der Prüfstelle 32 je nach Anordnung und/oder Größe der einzelnen Segmente 34 durch einen Fotowiderstand $R_p$ oder deren mehrere erfolgen.

Die Prüfstelle wird zweckmäßigerweise am Anfang oder am Ende der Anzeige angeordnet sein, sie kann aber auch an beliebiger anderer Stelle vorgesehen werden, sofern man die entsprechend längeren Leitungen in Kauf nimmt.

## Patentansprüche

1. Verfahren zur Überwachung einer mehrstelligen, im Multiplexverfahren betriebenen Anzeige, bei welcher jeweils gleichrangige Segment-Elektroden in Reihe miteinander verbunden sind, dadurch gekennzeichnet, daß den mit gleichrangigen Segment-Elektroden (12, 14) der Anzeige galvanisch verbundenen Segment-Elektroden (34) einer nicht der Anzeigeablesung dienenden Prüfstelle (32) während eines zusätzlichen Taktes der Multiplexschaltung ein Überprüfungssignal zugeführt wird.

2. Verfahren nach Anspruch 1, dadurch gekennzeichnet, daß die Prüfstelle (32) durch eine Einrichtung überwacht wird, die bei einem Defekt ein Alarmsignal auslöst.

3. Mehrstellige, im Multiplexverfahren betriebene Segmentanzeige, bei welcher gleichrangige Segment-Elektroden (12, 14) durch je eine gemeinsame Leitung (18) miteinander verbunden sind, zur Durchführung des Verfahrens nach Anspruch 1, dadurch gekennzeichnet, daß wenigstens ein Teil der Leitungen (18) ferner mit den Segmentelektroden (34) einer nicht der Anzeigeablesung dienenden Prüfstelle (32) verbunden ist.

4. Anzeige nach Anspruch 3, dadurch gekennzeichnet, daß zur Überwachung der Prüfstelle (32) wenigstens eine Fotozelle ($R_p$) und eine von dieser gesteuerten Alarmeinrichtung (48) vorgesehen ist.

## Claims

1. Method for monitoring a multiplexed display comprising a plurality of digits, wherein corresponding segment electrodes are connected in series to each other, characterized in that corresponding segment electrodes (12, 14) of the display are galvanically connected to segment electrodes (34) of a test unit (32), not serving for display reading purposes, the latter segment electrodes (34) being supplied with a test signal during an additional cycle of the multiplexing circuit.

2. Method as in claim 1, characterized in that the test unit (32) is monitored by a device which delivers an alarm signal in case of fail.

3. Multiplexed segment-display comprising a plurality of digits, in which corresponding segment electrodes (12, 14) are connected to each other by corresponding common leads (18), for performing the method as in claim 1, characterized in that at least some of the leads (18) are further connected to the segment electrodes (34) of a test unit (32) not serving for display reading purposes.

4. Display as in claim 3, characterized in that for monitoring the test unit (32) there is provided at least one foto cell ($R_p$) controlling an alarm device (48).

## Revendications

1. Procédé de surveillance d'un affichage à plusieurs chiffres fonctionnant en multiplex et dans lequel les électrodes de segment de même rang sont montées en série, caractérisé en ce qu'un signal de contrôle est dirigé pendant un cycle supplémentaire du circuit multiplex sur des électrodes de segment (34) qui font partie d'un poste de contrôle ne servant pas à la lecture de l'affichage et qui sont reliées galvaniquement aux électrodes de segment de même rang (12, 14) de l'affichage.

2. Procédé selon la revendication 1, caractérisé en ce que le poste de contrôle (32) est surveillé par un dispositif qui déclenche un signal d'avertissement en cas de défectuosité.

3. Affichage à segments à plusieurs chiffres, fonctionnant en multiplex et dans lequel un conducteur commun (18) relie les électrodes de segment de même rang (12, 14), affichage pour la mise en oeuvre du procédé selon la revendication 1 et caractérisé en ce qu'au moins une partie desdits conducteurs (18) est reliée aux électrodes de segment (34) d'un poste de contrôle (32) qui n'est pas utilisé pour la lecture de l'affichage.

4. Affichage selon la revendication 3, caractérisé en ce qu'au moins une cellule photo-électrique ($R_p$) et un dispositif d'avertissement (48) commandé par cette dernière sont destinés à la surveillance du poste de contrôle (32).

**Fig.1**

Fig. 2

Fig. 3